# EUROPEAN PATENT SPECIFICATION

(11) **EP 1 960 796 B1**
(45) Date of publication and mention of the grant of the patent: **07.05.2014**
(21) Application number: 05813809.0
(22) Date of filing: 28.11.2005
(51) Int. Cl.: G01R 15/18

(54) **PRECISION FLEXIBLE CURRENT SENSOR**
PRÄZISER FLEXIBLER STROMSENSOR
CAPTEUR DE COURANT SOUPLE DE PRÉCISION

(43) Date of publication of application: 27.08.2008
(73) Proprietor: Grno, Ladislav, 841 04 Bratislava (SK)
(72) Inventor: Grno, Ladislav, 841 04 Bratislava (SK)
(74) Representative: Cechvalova, Dagmar
(86) International application number: PCT/SK2005/000023
(87) International publication number: WO 2007/061390

(56) References cited:
- WO-A-96/28737
- DE-A1- 2 432 919
- US-A- 4 689 546
- US-A- 5 012 218
- US-A1- 2005 248 430
- US-B1- 6 614 218
- US-B1- 6 963 195
- PATENT ABSTRACTS OF JAPAN vol. 014, no. 340 (P-1080), 23 July 1990 (1990-07-23) -& JP 02 118460 A (ENERGY SUPPORT CORP), 2 May 1990 (1990-05-02)
- TORRES H ET AL: "DESIGN, CONSTRUCTION AND CALIBRATION OF THREE DEVICES TO MEASURE DIRECTLY LIGHTNING PARAMETERS" HIGH VOLTAGE ENGINEERING, 1999. ELEVENTH INTERNATIONAL SYMPOSIUM ON (CONF. PUBL. NO. 467) LONDON, UK 23-27 AUG. 1999, LONDON, UK,IEE, UK, 23 August 1999 (1999-08-23), pages 1-4, XP001152461 ISBN: 0-85296-719-5
- 'Das magnetische Feld', [Online] WWW.SCHREIBEN10.COM, pages 1 - 6 Retrieved from the Internet: <URL:http://www.schreiben10.com/referate/Ph ysik/9/DAS-MAGNETISCHE-FELD-reon.php> [retrieved on 2013-05-14]
- 'Bifilar-Wikipedia', [Online] HTTP://DE.WIKIPEDIA.ORG, pages 1 - 2 Retrieved from the Internet: <URL:http://de.wikipedia.org/wiki/Bifilar> [retrieved on 2013-05-14]

## Description

### Technical Field

The invention is related to sensor circuit for electrical alternating current. More particularly, the invention is directed to improvement of mechanical construction. Examples relate to electrical configuration, electronic evaluation circuit and use of flexible current sensor.

### Background of the Invention

The flexible current sensors are based on flexible inductive coil, which can be formed to create closed path around the measured current carrying conductor. The voltage induced into coil is proportional to the derivation of the total current flowing through the enclosed area. This principle of current measurement is well known as Rogowski principle or Rogowski coil following the publication by Rogowski W. and Steinhaus W. in 1912. Flexible current sensor generally has a form of sensing cable equipped with mechanical coupling system for either fixing or releasing said sensor cable ends to and from mutually closed position. The sensing cable consists of sensing coil wound on cylindrical flexible core, optional electrical shielding located over said sensing coil and outer isolation coat. In order to convert the coil voltage to output signal proportional to current an electronic integrator circuit is usually part of the flexible current sensor. The flexible sensors are advantageous for measurement of current in large size wires, difficult shape conductors and conductor groups.

Known constructions of the flexible current sensors have lower amplitude and phase accuracy compare to ferromagnetic current transformer types. The accuracy of flexible current sensors is affected mainly by sensor coil inhomogenity and by residual signals captured via capacitive and inductive coupling to strange voltage and current sources. Due to low level of the output voltage of the sensor coil they are sensitive to disturbance, interference and noise generated in evaluation electronics. Commercially available flexible current sensors are due to insufficient accuracy dedicated mainly for informative measurements.

Relevant solutions for Rogowski coil arrangements and respective electronics can be found in following references: US pat. No.4689546 (Stephens et al) discloses arrangement of air core current transformers.

UK patent No.GB2259150A discloses arrangements of electronic integrator with combined feedback.

US pat. No.5442280 discloses fixed Rogowski coil arrangements on printed circuit layout.

European Patent EP652441A1 discloses fixed Rogowski coil arrangements for installation with earthed metal casing.

US pat. No.6614218B1 discloses arrangements of combined passive and active integrator.

European Patent EP0834745A2 discloses arrangement of fixed Rogowski coil with high homogeneity.

Japanese patent JP2000065866 discloses multiple Rogowski coil arrangement for measurement of current flowing through large structure.

UK patent application No.GB2332784A discloses flexible Rogowski coil arrangements consisting of sensor coil wrapped on fixed support structure.

German patent application No.DE19811366A1 discloses flexible Rogowski coil arrangements optimized for repeated assembling on power line.

UK patent No.GB2342783A discloses fixed Rogowski coil arrangements on printed circuit layout.

German patent application No.DE19959789A1 discloses arrangements of electronic integrator with switched DC feedback.

US pat. No.6825650B1 discloses arrangements of series of fixed Rogowski coils for current measurement in electricity meter.

US pat. No.6313623B1 discloses spatial arrangements of two Rogowski coils eliminating residual signals.

US pat. Application No.US2003/0090356A1 discloses fixed Rogowski coil arrangements on printed circuit layout with optic transmission path.

The extreme linearity, lack of saturation of the non magnetic core and practically non limited frequency range are inherent property of the Rogowski principle based current sensors. These properties still invoke demand for their improvement and application oriented optimization.

US pat. No. 4689546 discloses Rogowski coil equipped with cascade of integrator circuit improving the frequency range of the sensor.

US pat. No.5012218 of Hauget al discloses compensation coil arrangement to minimise the end gap influence of the standard Rogowski coil sensor with central return wire.

German pat. No.2432919 of Hidde and Mueller discloses method of construction of fixed air core transformer consisting of areal arangement of mutually interconnected rigid coils.

US pat. 6963195 of Bergcan discloses arrangement of air-core fixed senig coil arrangement with sensing coil and shielding coil about pair of primary current conductors.

Pat. WO-A-9628737 of discloses construction of flexible current transformer with sensing coils wound on core consisting of soft magnetic material.

Therefore, it is an object for this invention to provide new and improved arrangement of flexible current sensor. Examples relate to its evaluation electronics yielding higher accuracy to and improvements in its applications.

### Summary of the invention

Improvement of flexible current sensor according to the invention as defined in claims 1 and 3, wherein:
The electrical shielding of the sensing cable consists of plurality of individually isolated shielding wires. The shielding wires are arranged into groups wound in mutually opposite directions. All shielding wires are electrically interconnected in parallel. Each shielding wire has only one connection point. Symmetrical arrangement of shielding consisting of plurality of wires yields high flexibility of sensing cable and minimizes the shielding effective impedance and thus increases the shielding performance.

The single connection point of each shielding wire eliminates any flow of induced currents, which would affect accuracy.

The sensing coil consists of plurality of individually isolated sensing wires. The sensing wires are arranged into groups wound in mutually opposite directions. The sensing wires, respective to voltages induced in sensing wires by magnetic field of sensed current, are electrically interconnected in series or in parallel or in combination of series and parallel or some sensing wires are idle. The interconnection configuration of sensing wires is used to determine the sensing coil sensitivity, impedance and frequency range. Symmetrical arrangement of sensing wires eliminates influence of strange current sources.

The shielding wires wound in opposite direction can be advantageously mutually twisted. The shielding wire twisting improves the mechanical stability of the winding and increases effective coverage. The shielding wire twisting also improves the electrical symmetry of wire groups thus lowering shielding impedance yielding further increasing of shielding performance.

The sensing wires wound in opposite direction can be advantageously mutually twisted. The sensing wire twisting improves the mechanical stability of the winding and thus increases the electrical stability as well. Essential effect of sensing wire twisting is the improvement of symmetry of sensing coil in reference to shielding. The symmetry enables elimination of all common mode residual signals induced by unwanted couplings of the sensing coil to strange sources

The flexible current sensor cable can be advantageously manufactured as continuous cable product on coaxial cable making machine with shielding wires and sensing wires arranged according to invention. The final sensor is then assembled from portion of desired length cut from already manufactured continuous cable. Continuous cable production assures high homogeneity of windings along the cable length thus increasing the sensor's accuracy and manufacturing repeatability. Further advantage is the lower manufacturing cost compare to individual sensor production.

Sensing coil inhomogenity caused by sensing coil termination and coupling system can be effectively reduced by compensation coil connected in series with sensing coil. The compensation coil can be advantageously located within the coupling system.

The symmetrical sensing coil of flexible current sensor is electrically balanced relative to shielding. Therefore essential elimination of all common mode residual signals induced by unwanted couplings of the sensing coil to strange sources can be accomplished by differential input stage of the electronic evaluation circuit. For low frequency applications the high impedance of input circuit assures high sensitivity and independence of output signal on the sensing coil resistance. For signals with high frequency content the sensing wires of sensing coil act as balanced transmission line with distributed parameters. For flat high frequency response the transmission line have to be matched with impedance equal to its characteristic impedance.

One alternative of coupling system for flexible current sensor consists of pair of cylindrical caps wherein each cap is from its back side equipped with cable hole for sensor cable, wherein first cap of said pair is on its front side equipped with cap hole for partial sinking of the front side of said second cap of said pair, wherein the wall of the cap hole is equipped with two fixing holes perpendicular to cap axis located on cap diagonal in opposite positions, wherein said second cap of said pair is equipped with fixing tips fitting into said fixing holes of the first cap, wherein one fixing hole is equipped with guiding notch for the fixing tip.

Another alternative of coupling system for flexible current sensor consists of plurality of segments equipped with tunnel for sensor cable and with facet or facet pairs. The facet system creates either closed path tunnel when multiple segments are stacked on one combination of facets and facet pairs or open path tunnel when multiple segments are stacked on another combination of facets and facet pairs.

Segments of the coupling system can be advantageously equipped with tip/hole pairs for determination of segment position in stack of segments.

Segments of the coupling system can be advantageously equipped with tunnels for stack positioning strings.

Flexible current sensor according to invention can be assembled from desired length portion of continuous sensor cable. Such sensor can be advantageously used as means for residual current measurement in large conductor groups for example building wiring and measurement of surge or lightning total and/or partial current in large structures for example buildings, towers or masts.

Due to low sensitivity of the flexible current sensor according to invention to strange signals and capability to spatial adjustment this flexible current sensor can be advantageously used as current measurement means within measuring devices for example in electricity meters.

The DC offset on output of electronic integrator circuit for flexible current sensor can be eliminated without affecting the AC accuracy in circuit consisting of operational amplifier, input resistor, integrating capacitor, decupling capacitor, first filter resistor, second filter resistor and filter capacitor. The input resistor is connected between input terminal of the integrator and inverting input terminal of the operational amplifier, the integrating capacitor is connected between inverting input terminal of the operational amplifier and output terminal of the integrator. The decupling capacitor is connected between output terminal of the operational amplifier and the integrator output terminal. The second filter resistor is connected between output terminal of the operational amplifier and first terminal of the filter capacitor. The first filter resistor is connected between inverting input terminal of the operational amplifier and first terminal of the filter capacitor. The second terminal of the filter capacitor is connected to electrical reference potential. The non-inverting input terminal of the operational amplifier is connected to electrical reference potential. The decoupling capacitor eliminates output of the DC content. The amplitude and phase accuracy is not affected by decoupling capacitor as the integrator's control feedback via integrating capacitor is taken directly from the output terminal.

Flexible current sensor cable sample according to invention has been manufactured for verification purpose as a continuous cable with sensing coil consisting of 2 x 4 isolated wires wound and twisted in mutually opposite direction on 7 mm diameter plastic core interconnected in series and with shielding consisting of 2 x 108 isolated wires wound and twisted in mutually opposite direction interconnected in parallel. Total outer diameter of the outer coat was 12 mm. The sensor was equipped with coupling system consisting of pair of cylindrical caps. The realized sensor has been used in precision electrical power measurement application as input circuit of working standard for electricity meter testing. The accuracy of the test system inclusive flexible sensor has been determined to be within limits 0.1% in amplitude and 0.1° in phase.

### Brief description of the drawings

Figure 1 shows principle of wire arrangement of shielding and/or sensing coil wound on cylindrical flexible core according to invention.
Figure 2 shows an example of parallel interconnection of shielding wires according to invention.
Figure 3 shows an example of serial interconnection of sensing wires according to invention.
Figure 4 shows an example of combination of serial and parallel interconnection of sensing wires.
Figure 5 shows an example of differential input arrangement of electronic integrator circuit.
Figure 6 shows example of minimized coupling system for flexible current sensor.
Figure 7 shows example of flexible current sensor assembled with coupling system according to figure 6.
Figure 8 shows an example of segment construction of coupling system for flexible current sensor.
Figure 9 shows a closed arrangement of the coupling system according to figure 8.
Figure 10 shows an open arrangement of the coupling system according to figure 8.
Figure 11 shows example fragment of flexible current sensor in current measurement application inside electricity meter.
Figure 12 shows example of flexible current sensor application for discharge current measurement on high voltage mast.
Figure 13 shows a minimized example of electronic integrator circuit for flexible current sensor.

### Description of Preferred Embodiment

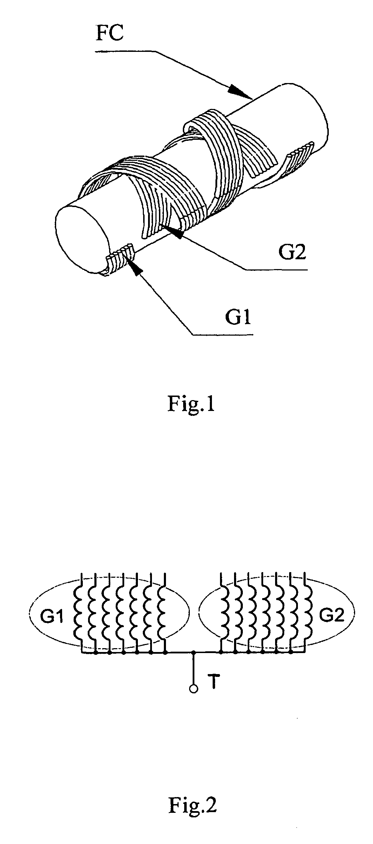

Figure 1 shows the principle of wire interconnection of shielding and/or sensing coil wound on cylindrical flexible core **FC** according to invention. The coil consists of plurality of individually isolated wires. The wires are divided into two groups **G1** and **G2.** The groups **G1** and **G2** are wound in mutually opposite directions and the wires of both groups are mutually twisted via periodic interchange of radial position.

Figure 2 shows an example of parallel interconnection of shielding wires according to invention. The shielding wires are divided into groups **G1** and **G2** wound in opposite direction. All shielding wires are electrically interconnected in parallel. Each shielding wire has only one connection point to common terminal **T.** The parallel configuration of wires of two equal groups wound in opposite direction mutually cancels the magnetic field caused by common capacitive coupling to external voltage source. Therefore the parallel configuration acts as low impedance compact shielding but with advantage of high mechanical flexibility and elimination of measurement error introduced by residual current, which would be induced by magnetic field of sensed current in compact shielding.

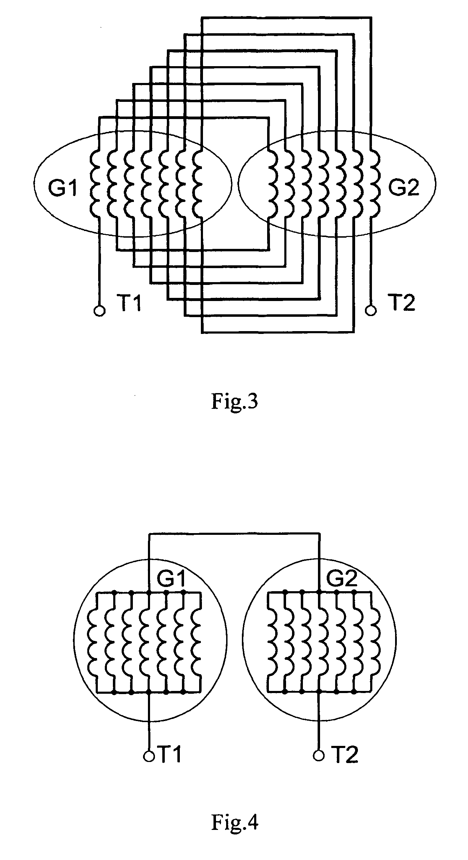

Figure 3 shows an example of serial interconnection of sensing wires according to invention. The sensing wires are divided into two groups **G1** and **G2.** The groups are wound in mutually opposite directions. All sensing wires are electrically interconnected in series. The voltages induced in individual wires by magnetic field of sensed current are in this arrangement added. The sum of voltages appears on terminals **T1** and **T2.** This arrangement is dedicated for applications where the highest sensitivity is required.

Figure 4 shows an example of combination of serial and parallel interconnection of sensing wires. The groups **G1** and **G2** are interconnected in series while the sensing wires of individual groups are electrically interconnected in parallel. This arrangement is dedicated for high current transient measurement applications in which low sensitivity, low coil impedance and broad frequency range is required.

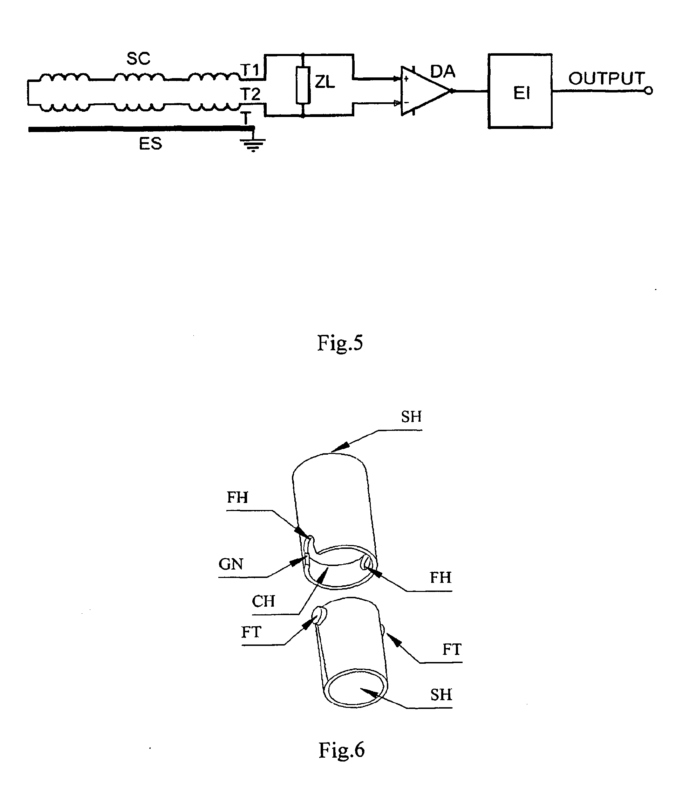

Figure 5 shows an example of differential input arrangement of electronic integrator circuit. The terminals **T1** and **T2** of sensor coil **SC** are connected to non-inverting and inverting inputs of differential amplifier **DA.** The common terminal **T** of parallel connected shielding wires is connected to electrical ground. The output of differential input stage **DA** is connected to input of electronic integrator **EI.** Optional matching by impedance **ZL** terminating the sensor coil optimizes the high frequency response of the sensor coil.

Figure 6 shows example of minimized coupling system for flexible current sensor. The fixing system consists of pair of cylindrical caps wherein each cap is in its back side equipped with cable hole **SH** for sensor cable, wherein first cap of said pair is on its front side equipped with cap hole **CH** for partial sinking of the front side of said second cap of said pair, wherein the wall of the cap hole **CH** is equipped with two fixing holes **FH** perpendicular to cap axis located on cap diagonal in opposite positions, wherein said second cap of said pair is equipped with fixing tips **FT** fitting into said fixing holes **FH** of the first cap, wherein one fixing hole **FH** is equipped with guiding notch **GN** for fixing tip **FT.** This fixing system has no moving part and therefore it is very compact and reliable.

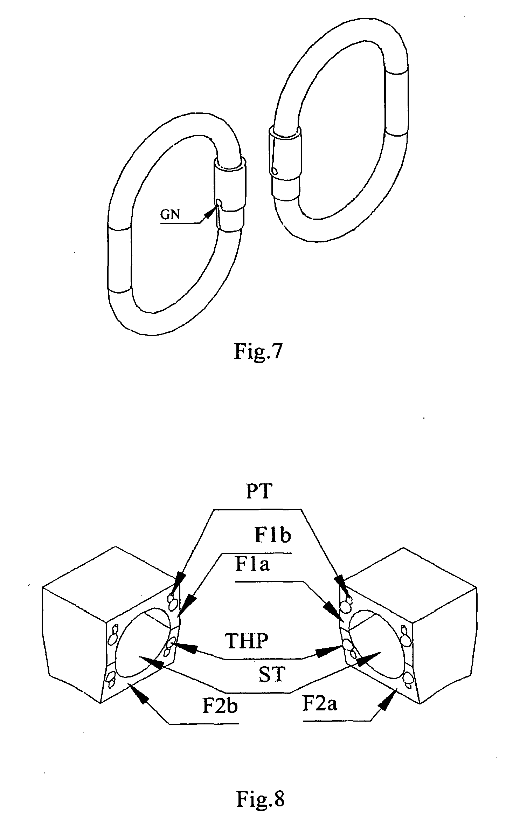

Figure 7 shows two views of flexible current sensor assembled with coupling system shown in figure 6. The appropriate assembling with the guiding notch **GN** located on the inner diameter of the closed sensor uses the natural centrifugal force of the bended sensor cable for additional fixation of the fixing caps in closed position.

Figure 8 shows an example of segment construction of coupling system for flexible current sensor. Coupling system for flexible current sensor consists of plurality of segments. The segments are equipped with tunnel **ST** for sensor and with facet pairs **F1a** / **F1b** and **F2a** / **F2b.** The segments are equipped with tip/hole pairs **THP** for determination of segment position in stack of segments. The segments are equipped with tunnels **PT** for stack positioning strings.

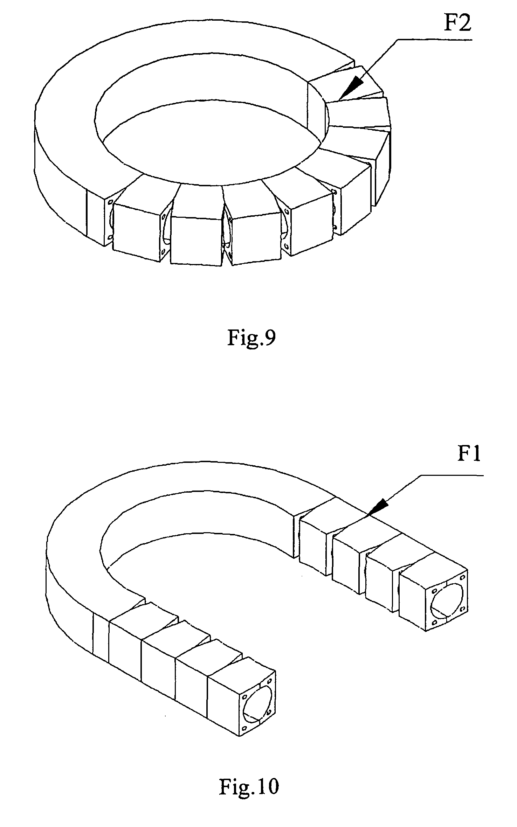

Figure 9 shows an example of closed arrangement of the coupling system shown in fig. 8. Multiple segments are stacked on facets **F2** and create closed path tunnel for sensor core. This is the working arrangement for measurement of current flowing through wire enclosed by the sensor.

Figure 10 shows an example of open arrangement of the coupling system shown in fig. 8. Multiple segments are stacked on facets **F1** and create open path tunnel for sensor core. This is the positioning arrangement when the sensor can be positioned over current carrying wire and then closed to working arrangement.

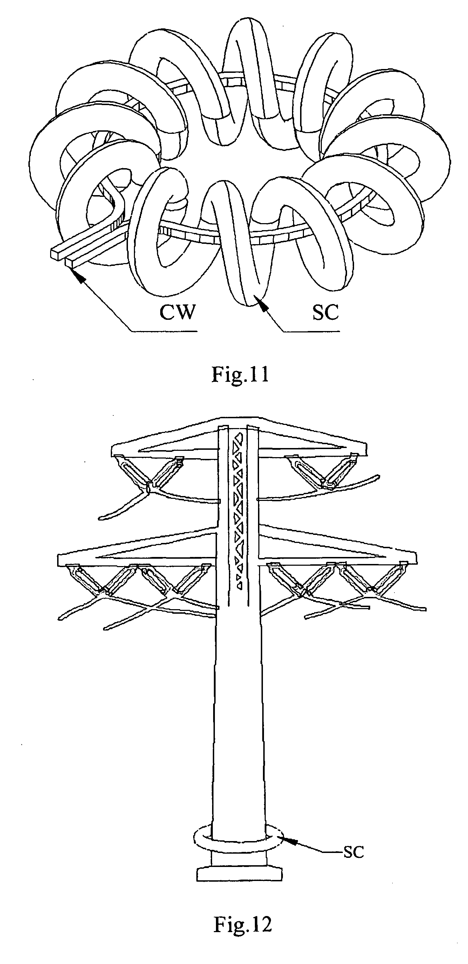

Figure 11 shows example fragment of flexible current sensor in current measurement application inside electricity meter. The meter's current wire **CW** is sensed by multiple turns of sensor cable **SC** according to invention. Multiple turn lead to proportional sensitivity increase.

Figure 12 shows example of flexible current sensor application for discharge current measurement on high voltage mast. The mast is equipped with flexible current sensor cable **SC** for measurement of total current flowing through mast stem into the earth.

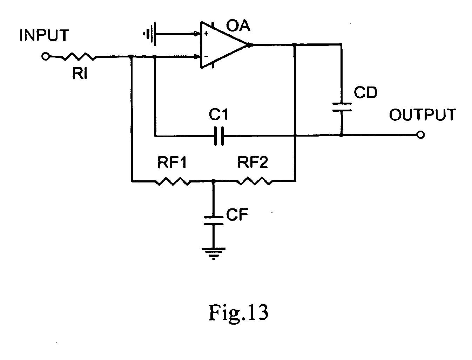

Figure 13 shows a minimized example of electronic integrator circuit for flexible current sensor. Electronic integrator circuit consists of operational amplifier **OA,** input resistor **RI,** integrating capacitor **C1**, decupling capacitor **CD,** first filter resistor **RF1,** second filter resistor **RF2** and filter capacitor **CF.** The input resistor RI is connected between integrator input terminal and inverting input terminal of operational amplifier **OA.** The integrating capacitor **C1** is connected between inverting input terminal of the operational amplifier **OA** and integrator output terminal. The decupling capacitor **CD** is connected between output terminal of the operational amplifier **OA** and integrator output terminal. The second filter resistor **RF2** is connected between output terminal of the operational amplifier **OA** and first terminal of the filter capacitor **CF.** The first filter resistor **RF1** is connected between inverting input terminal of the operational amplifier **OA** and first terminal of the filter capacitor **CF.** Second terminal of the filter capacitor **CF** is connected to electrical reference potential. Non-inverting input terminal of the operational amplifier **OA** is connected to electrical reference potential. Output signal of the integrator circuit is free of DC offset due to decoupling capacitor **CD.** The amplitude and phase accuracy is not affected by decoupling capacitor **CD** as the integrator control feedback via integrating capacitor **C1** is taken from the integrator output terminal.

## Claims

1. A flexible current sensor in form of a sensor cable consisting of a sensing coil wound on a cylindrical flexible core, an electrical shielding located over said sensing coil and an outer isolation coat equipped with a mechanical coupling system for either fixing or releasing sensor cable ends to and from mutually closed position, said electrical shielding comprising a symmetrical arrangement consisting of a plurality of individually isolated shielding wires arranged into groups wound along the length of said cylindrical flexible core in mutually opposite directions wherein said individually isolated shielding wires are mutually electrically interconnected in parallel, and each shielding wire has only one connection point.

2. A flexible current sensor according to claim 1, ***characterised in that*** said sensing coil consists of a plurality of individually isolated sensing wires arranged into groups wound in mutually opposite directions.

3. A flexible current sensor in form of a sensor cable consisting of a sensing coil wound on a cylindrical flexible core, an electrical shielding located over said sensing coil and an outer isolation coat equipped with a mechanical coupling system for either fixing or releasing sensor cable ends to and from mutually closed position, said sensing coil consists of a plurality of individually isolated sensing wires arranged into two groups wherein said groups are wound in mutually opposite directions and the sensing wires of both groups are mutually twisted via periodic interchange of radial position.

4. A flexible current sensor according to claim 2 or 3, ***characterised in* that** said sensing wires, respective to voltages induced in the sensing wires by the magnetic field of a sensed current, are electrically interconnected in series or in parallel or a combination of series and parallel or some sensing wires remain idle respective to voltages induced in the sensing wires by the magnetic field of the sensed current, wherein a configuration of said sensing wires is determined by a required sensitivity, an impedance and a frequency range of said current sensor.

5. The flexible current sensor according to claim 1, wherein said shielding wires wound in opposite direction are mutually twisted.

## Patentansprüche

1. Flexibler Stromsensor in Form eines Sensorkabels, bestehend aus einer am flexiblen Zylinderkern gewickelten Messspule, elektrischer Schirmung über der genannten Messspule und einem Außen-Isolierungsmantel, ausgestattet mit einem mechanischen Verbindungssystem entweder zur Befestigung oder Lösung von Sensorkabelenden in eine geschlossene bzw. geöffnete Stellung, die genannte elektrische Schirmung ist symmetrisch ausgeführt, bestehend aus einer bestimmten Anzahl von separat isolierten Schirmleitern, die entlang des flexiblen Zylinderkerns in zueinander in Gegenrichtung gewickelten Gruppen angeordnet sind, wobei die genannten separat isolierten Schirmleiter miteinander parallel elektrisch geschaltet sind und jeder Schirmleiter nur einen Anschlusspunkt hat.

2. Flexibler Stromsensor nach Anspruch 1, **dadurch gekennzeichnet, dass** die Messspule aus einer bestimmten Anzahl von separat isolierten Messleiter, die in zueinander in Gegenrichtung gewickelten Gruppen angeordnet sind, besteht.

3. Flexibler Stromsensor in Form eines Sensorkabels, bestehend aus einer am flexiblen Zylinderkern gewickelten Messspule, elektrischer Schirmung über der genannten Messspule und einem Außen-Isolierungsmantel, ausgestattet mit einem mechanischen Verbindungssystem entweder zur Befestigung oder Lösung von Sensorkabelenden in eine geschlossene bzw. geöffnete Stellung, die genannte Messspule besteht aus einer bestimmten Anzahl von separat isolierten, in zwei Gruppen angeordneten Messleitern, wobei diese Gruppen gegenseitig in Gegenrichtung gewickelt und die Messleiter von beiden Gruppen gegenseitig durch periodischen Wechsel der Radialstellung verdrillt sind.

4. Flexibler Stromsensor nach Anspruch 2 oder 3, **dadurch gekennzeichnet, dass** die genannten Messleiter, in Beziehung an der in den Messleitern durch Magnetfeld des gemessenen Stroms induzierten Spannungen, in Reihe oder parallel oder durch Kombination der Reihen- und Parallelschaltung elektrisch geschaltet sind oder bleiben bestimmte Messleiter in Beziehung an der in den Messleitern durch Magnetfeld des gemessenen Stroms induzierten Spannungen inaktiv, **dadurch gekennzeichnet, dass** die Konfiguration der genannten Messleitern auf der Grundlage der gewünschten Empfindlichkeit, Impedanz und Frequenzbereichs des genannten Stromsensors zu bestimmen ist.

5. Flexibler Stromsensor nach Anspruch 1, **dadurch gekennzeichnet, dass** die genannten Schirmleiter, die in der Gegenrichtung gewickelt sind, verdrillt sind.

## Revendications

1. Capteur flexible de courant en forme d'un capteur à câble constitué d' une bobine de détection enroulée sur une âme cylindrique flexible, d' un blindage électrique étant situé au-dessus de ladite bobine de détection et d'une couche d'isolation externe, équipé d'un système de couplage mécanique pour soit fixer ou libérer les fins d'un capteur à câble soit à la position soit de la position mutuellement fermée, ledit blindage électrique comprenant un agencement symétrique constitué d' une pluralité des fils de blindage isolés individuellement et disposés en groupes enroulés le long de la longueur de ladite âme souple cylindrique dans des directions mutuellement opposées, dans lequel lesdits fils de blindage isolés individuellement sont mutuellement interconnectés électriquement en parallèle, et chaque fil de blindage a un seul point de connexion.

2. Capteur flexible de courant selon la revendication 1, **caractérisé en ce que** ladite bobine de détection est constituée d'une pluralité de fils de détection isolés individuellement et disposés en groupes enroulées dans des directions mutuellement opposées.

3. Capteur flexible de courant en forme d'un capteur à câble constitué d' une bobine de détection enroulée sur une âme cylindrique flexible , d' un blindage électrique étant situé au-dessus de ladite bobine de détection et d'une couche d'isolation externe, équipé d'un système de couplage mécanique pour soit fixer ou libérer les fins d'un capteur à câble soit à la position soit de la position mutuellement fermée, ladite bobine de détection est constituée d'une pluralité de fils de détection isolés individuellement et disposés en deux groupes, lesdits groupes sont enroulées dans des directions mutuellement opposées, et les fils de détection de ces deux groupes sont mutuellement torsadés via l'échange périodique de la position radiale.

4. Capteur flexible de courant selon la revendication 2 ou 3, **caractérisé en ce que** lesdits fils de détection, respectivement à des tensions induites dans les fils de détection par le champ magnétique d'un courant détecté, sont reliés électriquement entre eux en série ou en parallèle ou en une combinaison de série et en parallèle ou des fils de détection restent inactifs respectivement à des tensions induites dans les fils de détection par le champ magnétique du courant détecté, dans lequel une configuration desdits fils de détection est déterminé par une sensibilité requise, une impédance et une gamme de fréquence dudit capteur de courant.

5. Capteur de courant flexible selon la revendication 1, dans lequel lesdits fils métalliques de blindage enroulés dans des directions opposées sont mutuellement torsadés.
